# EUROPEAN PATENT APPLICATION

(11) **EP 4 336 307 A1**
(43) Date of publication of application: **13.03.2024**
(21) Application number: 23753780.8
(22) Date of filing: 28.06.2023
(51) Int. Cl.: G06F 1/16, H04M 1/02, F16C 11/04

(54) **HINGE APPARATUS AND ELECTRONIC DEVICE COMPRISING SAME**

(30) Priority: 19.07.2022 KR 20220089082; 23.09.2022 KR 20220120957
(71) Applicant: Samsung Electronics Co., Ltd., Suwon-si, Gyeonggi-do 16677 (KR)
(72) Inventor: KIM, Dooryong, Suwon-si, Gyeonggi-do 16677 (KR); HWANG, Sungkyu, Suwon-si, Gyeonggi-do 16677 (KR); LIM, Minjong, Suwon-si, Gyeonggi-do 16677 (KR)
(74) Representative: Gulde & Partner
(86) International application number: PCT/KR2023/009012
(87) International publication number: WO 2024/019350

(57) **Abstract**

An electronic device according to an embodiment of the disclosure may include a first housing, a second housing, and a hinge apparatus configured to foldably connect the first housing and the second housing to each other. The hinge apparatus may include a bracket including a first coupling portion and a second coupling portion spaced apart from the first coupling portion, a first rotator including a first rotating portion fastened to the first coupling portion of the bracket to rotate relative to the bracket, a second rotator including a second rotating portion fastened to the second coupling portion of the bracket to rotate relative to the bracket, and a damper disposed on at least one of the first coupling portion and the second coupling portion to come into contact with at least one of the first rotating portion and the second rotating portion depending on a degree of rotation of the first rotator and the second rotator relative to the bracket.

## Description

### [Technical Field]

Various embodiments disclosed herein relate to a hinge apparatus and an electronic device including the hinge apparatus. For example, embodiments of a hinge apparatus included in a foldable electronic device which is folded or unfolded may be included.

### [Background Art]

Hinge structures are widely used across overall industry as structures for rotatably connecting mechanical components. For example, a hinge structure may be applied to a foldable electronic device.

With the technological development of components included in electronic devices, various types of electronic devices are being developed. In particular, as foldable displays have been developed with the technological development of displays that visually display information, new-concept electronic devices are emerging.

For example, a foldable electronic device may be implemented by applying a foldable display. As electronic devices having such a new form factor appear, demand for technology development for components that rotatably connect housings of electronic devices are also increasing.

### [Disclosure of Invention]

### [Technical Problem]

In order to increase usability in a process of folding a foldable electronic device, a stop operation and a free-stop operation may be required. The stop operation may refer to an operation in which the electronic device is maintained in the fully folded state or the fully unfolded state. The free-stop operation may refer to an operation in which the electronic device maintains its state when an external force of a predetermined level or more does not act while the electronic device is switched from the folded state to the unfolded state.

In particular, in the case of a portable electronic device, since it is important to implement the electronic device in a compact size, a hinge apparatus included in the electronic device needs to be compactly designed.

On the other hand, when a sudden change of direction is transmitted to a hinge apparatus in the process of implementing the stop operation and the free-stop operation, or when a separation occurs between the components of a hinge apparatus due to the dropping of the electronic device, vibration or noise may occur during the operation of the hinge apparatus. In this case, the operation feeling of the hinge apparatus may be deteriorated.

### [Solution to Problem]

A hinge apparatus disclosed in an embodiment of the disclosure is configured in a relatively simple structure. Thus, it is possible to implement the hinge apparatus in a compact size and to reduce vibration or noise generated from the hinge apparatus so that the operation feeling of the electronic device can be improved.

An electronic device according to an embodiment of the disclosure may include a first housing, a second housing, and a hinge apparatus configured to foldably connect the first housing and the second housing to each other. The hinge apparatus may include a bracket including a first coupling portion and a second coupling portion spaced apart from the first coupling portion, a first rotator including a first rotating portion fastened to the first coupling portion of the bracket to rotate relative to the bracket, a second rotator including a second rotating portion fastened to the second coupling portion of the bracket to rotate relative to the bracket, and a damper disposed on at least one of the first coupling portion and the second coupling portion to come into contact with at least one of the first rotating portion and the second rotating portion depending on a degree of rotation of the first rotator and the second rotator relative to the bracket.

A hinge apparatus according to an embodiment of the disclosure may include a bracket including a first coupling portion and a second coupling portion spaced apart from the first coupling portion, a first rotator including a first rotating portion fastened to the first coupling portion of the bracket to rotate relative to the bracket, a second rotator including a second rotating portion fastened to the second coupling portion of the bracket to rotate relative to the bracket, and a damper disposed on at least one of the first coupling portion and the second coupling portion to come into contact with at least one of the first rotating portion and the second rotating portion depending on a degree of rotation of the first rotator and the second rotator relative to the bracket.

### [Advantageous Effects of Invention]

According to an embodiment disclosed herein, since a hinge apparatus having a relatively simple structure is implemented, it is possible to manufacture the hinge apparatus to be compact. As a result, it is possible to reduce the volume of a hinge driver of an electronic device so that an electronic device can be manufactured to be compact as a whole.

In addition, a damper structure configured to reduce vibration or noise generated from a hinge apparatus may be disposed inside the hinge apparatus. Through this, it is possible to reduce vibration or noise generated from the hinge apparatus to improve the operation feeling of the electronic device.

### [Brief Description of Drawings]

In connection with the description of the drawings, the same or similar components may be denoted by the same or similar reference numerals.
FIGS. 1A and 1B are a front view and a rear view of an electronic device according to an embodiment of the disclosure in an unfolded state.
FIGS. 2A and 2B are a front view and a rear view of the electronic device according to an embodiment of the disclosure in a folded state.
FIG. 3 is an exploded perspective view of the electronic device according to an embodiment of the disclosure.
FIG. 4A is an exploded perspective view of the electronic device according to an embodiment of the disclosure.
FIG. 4B is a view illustrating a state in which hinge apparatuses according to an embodiment of the disclosure are assembled to the electronic device.
FIG. 5A is a front view of a hinge apparatus according to an embodiment of the disclosure.
FIG. 5B is a rear view of the hinge apparatus according to an embodiment of the disclosure.
FIG. 5C is a perspective view of the hinge apparatus according to an embodiment of the disclosure.
FIG. 6A is an exploded perspective view of the hinge apparatus according to an embodiment of the disclosure.
FIG. 6B is a front view of the hinge apparatus according to an embodiment of the disclosure in the folded state.
FIG. 6C is a cross-sectional view of the hinge apparatus according to an embodiment of the disclosure taken along line B-B of FIG. 6B.
FIG. 7 is a view for explaining a position where a rotating portion of a rotator and a damper come into contact with each other according to an embodiment of the disclosure.
FIGS. 8A to 8D are views illustrating the degree of contact of the rotator with the damper depending on the rotational state of the rotator according to an embodiment of the disclosure.

### [Mode for the Invention]

It is to be understood that various embodiments of the disclosure and terms for describing the embodiments are not intended to limit the technical features disclosed herein to specific embodiments, and that the embodiments include various modifications, equivalents, and/or substitutions of the corresponding embodiments.

In connection with the description made with reference to the drawings, similar or related components may be denoted by similar reference numerals. The singular form of a noun corresponding to an item may include one item or a plurality of items unless the context clearly indicates otherwise.

In this document, each of phrases such as "A or B", "at least one of A and B", "at least one of A or B", "A, B, or C", "at least one of A, B, and C," and "at least one of A, B, or C" may include one of the items listed together in the corresponding one of the phrases, or all possible combinations thereof. Terms such as "1^{st}," "2^{nd}," "first," and "second" may simply be used to distinguish a given component from other corresponding components and do not limit the corresponding components in other aspects (e.g., importance or order). When a certain (e.g., a first) component is mentioned as being "coupled" or "connected" to another (e.g., a second) component, with or without the term "functionally" or "communicatively", it means that the certain component may be connected to the other component directly (e.g., in a wired manner), wirelessly, or via a third component.

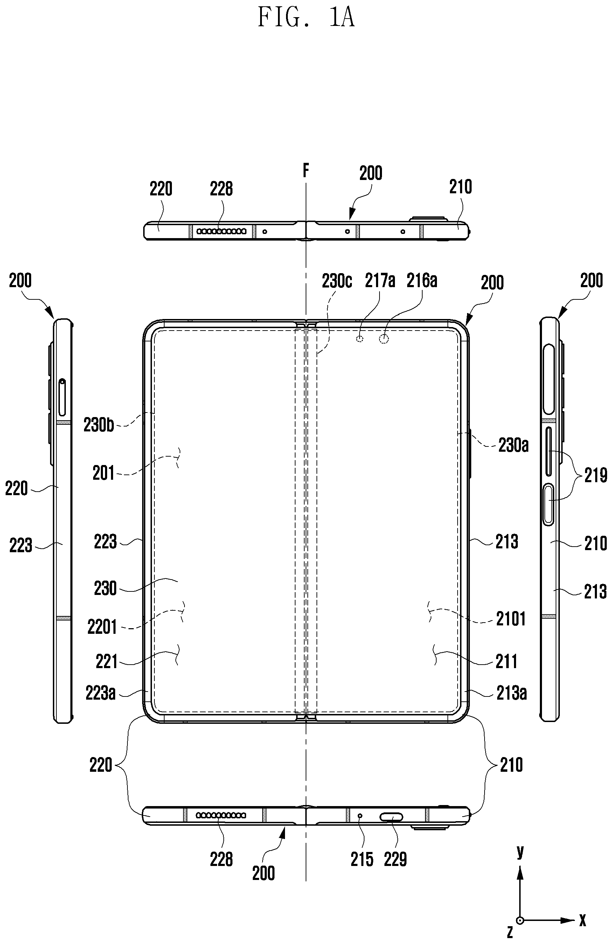

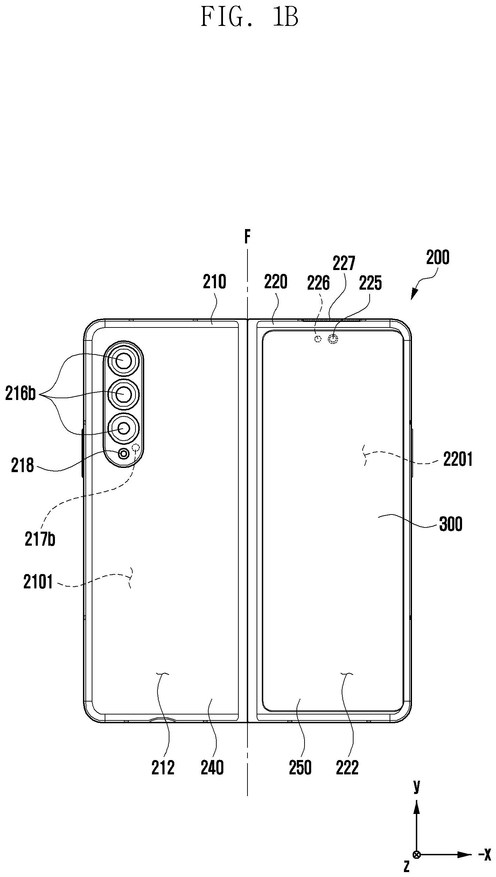

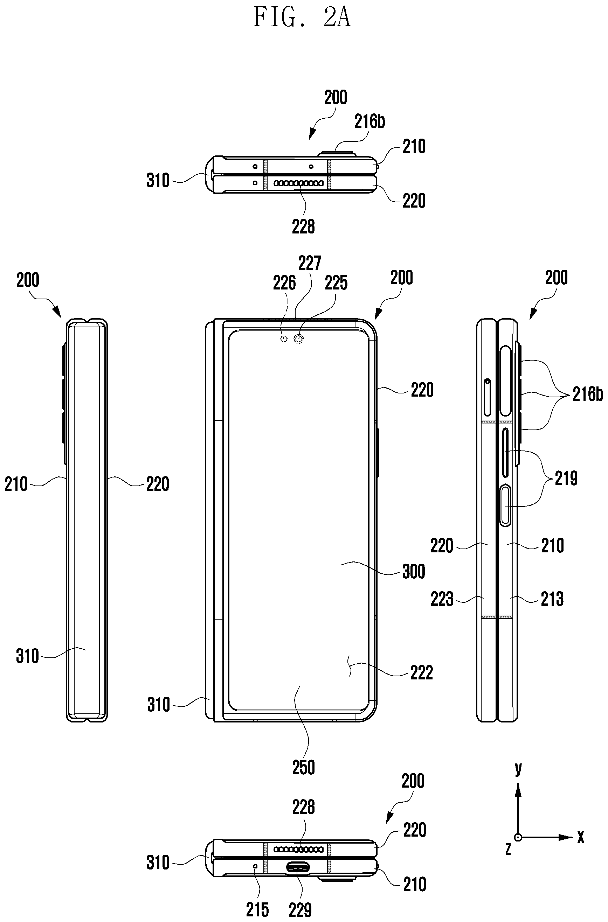

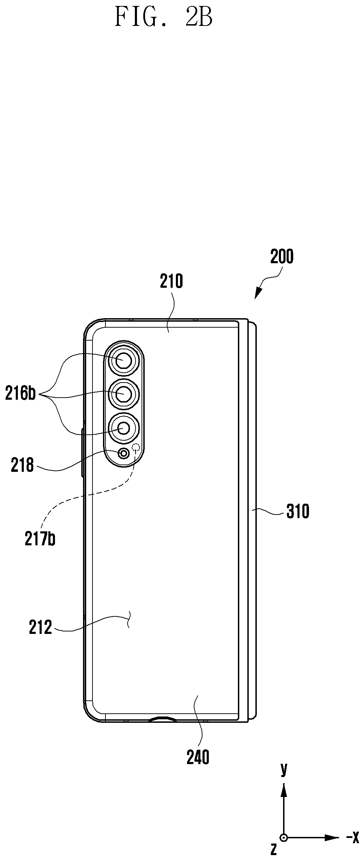

FIGS. 1A and 1B illustrate a front view and a rear view of an unfolded stateof an electronic device according to various embodiments of the disclosure. FIGS. 2A and 2B illustrate a front view and a rear view of a folded state of an electronic device according to various embodiments of the disclosure.

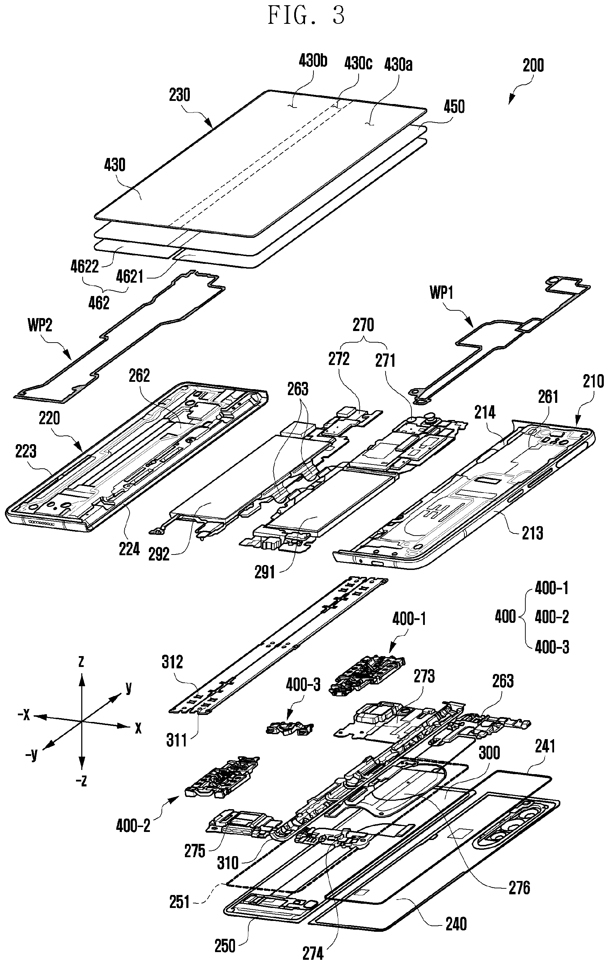

Referring to FIGS. 1A to 2B, an electronic device 200 includes a pair of housings 210 and 220 (e.g., a foldable housing structure) rotatably coupled to each other with reference to folding axis F through at least one hinge device (e.g., a hinge device 400-1, 400-2 of FIG. 3) (e.g., a hinge module) so as to be folded with respect to each other, a first display 230 (e.g., a flexible display, a foldable display, or a main display) disposed through the pair of housings 210 and 220, and/or a second display 300 (e.g., a sub display) disposed through the second housing 220. According to an embodiment, at least a part of the hinge device (e.g., the hinge device 400-1, 400-2 of FIG. 3) may be disposed so as not to be seen from the outside through the first housing 210 and the second housing 220, and may be disposed so as not to be seen from the outside through the hinge housing 310 covering a foldable portion. In the disclosure, a surface in which the first display 230 is disposed may be defined as a front surface of the electronic device 200, and a surface opposite to the front surface may be defined as a rear surface of the electronic device 200. In addition, a surface surrounding a space between the front surface and the rear surface may be defined as a side surface of the electronic device 200.

According to various embodiments, the pair of housings 210 and 220 include a first housing 210 and a second housing 220 foldably arranged with respect to each other through the hinge device (e.g., the hinge device 400-1, 400-2 of FIG. 3). According to an embodiment, the shape and the coupling of the pair of housings 210 and 220 are not limited to those illustrated in FIGS. 1A to 2B, and the pair of housings 210 and 220 may be implemented by a combination and/or coupling of other shapes or components. According to an embodiment, the first housing 210 and the second housing 220 may be arranged on opposite sides with reference to the folding axis F, and may have shapes that are entirely symmetric to each other with respect to the folding axis F. According to an embodiment, the first housing 210 and the second housing 220 may be asymmetrically folded with reference to the folding axis F. According to an embodiment, the angle or the distance between the first housing 210 and the second housing 220 may vary depending on whether the electronic device 200 is in an unfolded state, a folded state, or an intermediate state.

According to various embodiments, the first housing 210 may include, in the unfolded state of the electronic device 200, a first surface 211 connected to the hinge device (e.g., the hinge device 400-1, 400-2 of FIG. 3) and disposed to be oriented to the front surface of the electronic device 200, a second surface 212 oriented in a direction opposite to the first surface 211, and/or a first side member 213 surrounding at least a part of a first space 2101 between the first surface 211 and the second surface 212. According to an embodiment, the second housing 220 may include, in the unfolded state of the electronic device 200, a third surface 221 connected to the hinge device (e.g., the hinge device 400-1, 400-2 of FIG. 3) and disposed to be oriented to the front surface of the electronic device 200, a fourth surface 222 oriented in a direction opposite to the third surface 221, and/or a second side member 223 surrounding at least a part of a second space 2201 between the third surface 221 and the fourth surface 222. According to an embodiment, the first surface 211 and the third surface 221 may be oriented in substantially the same direction in the unfolded state, and the first surface 211 and the third surface 221 may at least partially face each other in the folded state. According to an embodiment, the electronic device 200 may include a recess 201 formed to receive the first display 230 through structural coupling of the first housing 210 and the second housing 220. According to an embodiment, the recess 201 may have substantially the same shape as the first display 230. According to an embodiment, the first housing 210 may include a first protection frame 213a (e.g., a first decoration member) which is, when seen from above the first display 230, coupled to the first side member 213, disposed to overlap with an edge of the first display 230, so as to cover the edge of the first display 230 to allow the same not to be seen from the outside. According to an embodiment, the first protection frame 213a may be integrally formed with the first side member 213. According to an embodiment, the second housing 220 may include a second protection frame 223a (e.g., a second decoration member) which is, when seen from above the first display 230, coupled to the second side member 223, disposed to overlap with an edge of the first display 230, so as to cover the edge of the first display 230 to allow the same not to be seen from the outside. According to an embodiment, the second protection frame 223a may be integrally formed with the second side member 223. In an embodiment, the first protection frame 213a and the second protection frame 223a may be omitted.

According to various embodiments, the hinge housing 310 (e.g., a hinge cover) may be disposed between the first housing 210 and the second housing 220, and may be disposed to cover a part (e.g., at least one hinge module) of the hinge device (e.g., the hinge device 400-1, 400-2 of FIG. 3) disposed on the hinge housing 310. According to an embodiment, the hinge housing 310 may be hidden or exposed from or to the outside by a part of the first housing 210 and the second housing 220 according to the unfolded state, the folded state, or the intermediate state of the electronic device 200. For example, when the electronic device 200 is in the unfolded state, at least a part of the hinge housing 310 may be covered by the first housing 210 and the second housing 220 and not be substantially exposed. According to an embodiment, when the electronic device 200 is in the folded state, at least a part of the hinge housing 310 may be exposed to the outside between the first housing 210 and the second housing 220. According to an embodiment, in the intermediate state in which the first housing 210 and the second housing 220 are folded with each other by a predetermined angle (folded with a certain angle), the hinge housing 310 may be at least partially exposed to the outside of the electronic device 200 between the first housing 210 and the second housing 220. For example, an area in which the hinge housing 310 is exposed to the outside, may be smaller than that in a case in which the electronic device 200 is completely folded. According to an embodiment, the hinge housing 310 may include a curved surface.

According to various embodiments, when the electronic device 200 is in the unfolded state (e.g., the states shown in FIGS. 1A and 1B), the first housing 210 and the second housing 220 may meet at an about 180-degree angle, and a first area 230a, a second area 230b, and a folding area 230c of the first display 230 may form the same plane and arranged to be oriented in substantially the same direction (e.g., a z-axis direction). In another embodiment, when the electronic device 200 is in the unfolded state, the first housing 210 may rotate by an about 360-degree angle with respect to the second housing 220, and may be outwardly folded (an outfolding scheme) so that the second surface 212 and the fourth surface 222 face each other.

According to various embodiments, when the electronic device 200 is in the folded state (e.g., the states shown in FIGS. 2A and 2B), the first surface 211 of the first housing 210 and the third surface 221 of the second housing 220 may be arranged to face each other. In this case, the first area 230a and the second area 230b of the first display 230 may form a narrow angle (e.g., a range between 0 degree to about 10 degrees) through the folding area 230c, and may be arranged to face each other. According to an embodiment, at least a part of the folding area 230c may be deformed into a curved shape having a predetermined curvature. According to an embodiment, when the electronic device 200 is in the intermediate state, the first housing 210 and the second housing 220 may be arranged at a predetermined angle (a certain angle). In this case, the first area 230a and the second area 230b of the first display 230 may form an angle that is greater than that in the folded state and smaller than that in the unfolded state, and the curvature of the folding area 230c may be lower than that in the folded state, and may be higher than that in the unfolded state. In an embodiment, the first housing 210 and the second housing 220 may form an angle which allows stopping at a designated folding angle between the folded state and the unfolded state (a free stop function), through the hinge device (e.g., the hinge device 400-1, 400-2 of FIG. 3). In an embodiment, the first housing 210 and the second housing 220 may continuously operate while being pressed in an unfolding direction or a folding direction with reference to a designated inflection angle, through the hinge device (e.g., the hinge device 400-1, 400-2 of FIG. 3).

According to various embodiments, the electronic device 200 may include at least one of at least one display 230 and 300 disposed on the first housing 210 and/or the second housing 220, an input device 215, sound output devices 227 and 228, sensor modules 217a, 217b, and 226, camera modules 216a, 216b, and 225, a key input device 219, an indicator (not shown), or a connector port 229. In an embodiment, the electronic device 200 may omit at least one of the elements, or may additionally include at least one another element.

According to various embodiments, the at least one display 230 and 300 may include a first display 230 (e.g., a flexible display) disposed to be supported by the third surface 221 of the second housing 220 from the first surface 211 of the first housing 210 through the hinge device (e.g., the hinge device 400-1, 400-2 of FIG. 3), and a second display 300 disposed to be at least partially seen from the outside through the fourth surface 222 in a space in the second housing 220. In an embodiment, the second display 300 may be disposed to be seen from the outside through the second surface 212 in a space in the first housing 210. According to an embodiment, the first display 230 may be mainly used in the unfolded state of the electronic device 200, and the second display 300 may be mainly used in the folded state of the electronic device 200. According to an embodiment, the electronic device 200 may control, in the intermediate state, the first display 230 and/or the second display 300 to be used, based on a folding angle between the first housing 210 and the second housing 220.

According to various embodiments, the first display 230 may be disposed in a receiving space formed by the pair of housings 210 and 220. For example, the first display 200 may be disposed in a recess 201 formed by the pair of housings 210 and 220, and may be disposed to occupy substantially the most of the front surface of the electronic device 200in the unfolded state. According to an embodiment, the first display 230 may include a flexible display having at least one area which can be deformed into a plane or a curved surface. According to an embodiment, the first display 230 may include the first area 230a facing the first housing 210 and the second area 230b facing the second housing 220. According to an embodiment, the first display 230 may include the folding area 230c including a part of the first area 230a and a part of the second area 230b with respect to the folding axis F. According to an embodiment, at least a part of the folding area 230c may include an area corresponding to the hinge device (e.g., the hinge device 400-1, 400-2 of FIG. 3). According to an embodiment, a division of an area of the first display 230 merely corresponds to exemplary physical division by the pair of housings 210 and 220 and the hinge device (e.g., the hinge device 400-1, 400-2 of FIG. 3), and the first display 230 may be substantially displayed as one seamless full screen through the pair of the housings 210 and 220 and the hinge device (e.g., the hinge device 400-1, 400-2 of FIG. 3). According to an embodiment, the first area 230a and the second area 230b may have shapes that are entirely symmetric or partially asymmetric to each other with respect to the folding area 230c.

According to various embodiments, the electronic device 200 may include a first rear cover 240 disposed on the second surface 212 of the first housing 210 and a second rear cover 250 disposed on the fourth surface 222 of the second housing 220. In an embodiment, at least a part of the first rear cover 240 may be integrally formed with the first side member 213. In an embodiment, at least a part of the second rear cover 250 may be integrally formed with the second side member 223. According to an embodiment, at least one of the first rear cover 240 and the second rear cover 250 may be substantially formed of a transparent plate (e.g., a polymer plate or glass plate including various coding layers) or an opaque plate. According to an embodiment, the first rear cover 240 may be formed of, for example, an opaque plate such as coded or colored glass, ceramic, polymer, metal (e.g., aluminum, stainless steel (STS), or magnesium), or a combination of at least two of the materials above. According to an embodiment, the second rear cover 250 may be substantially formed of, for example, a transparent plate such as glass or polymer. Accordingly, the second display 300 may be disposed to be seen from the outside through the second rear cover 250 in a space in the second housing 220.

According to various embodiments, the input device 215 may include a microphone. In an embodiment, the input device 215 may include multiple microphones arranged to detect the direction of sound. According to an embodiment, the sound output devices 227 and 228 may include speakers. According to an embodiment, the sound output devices 227 and 228 may include a call receiver 227 disposed through the fourth surface 222 of the second housing 220 and an external speaker 228 disposed through at least a part of the second side member 223 of the second housing 220. In an embodiment, the input device 215, the sound output devices 227 and 228, and the connector 229 may be disposed in spaces of the first housing 210 and/or the second housing 220, and may be exposed to an external environment through at least one hole formed through the first housing 210 and/or the second housing 220. In an embodiment, holes formed through the first housing 210 and/or the second housing 220 may be commonly used for the input device 215 and the sound output devices 227 and 228. In an embodiment, the sound output devices 227 and 228 may include a speaker (e.g., a piezo speaker) operating without including a hole formed through the first housing 210 and/or the second housing 220.

According to various embodiments, the camera modules 216a, 216b, and 225 may include a first camera module 216a disposed on the first surface 211 of the first housing 210, a second camera module 216b disposed on the second surface 212 of the first housing 210, and/or a third camera module 225 disposed on the fourth surface 222 of the second housing 220. According to an embodiment, the electronic device 200 may include a flash 218 disposed around the second camera module 216b. According to an embodiment, the flash 218 may include, for example, a light-emitting diode or a xenon lamp. According to an embodiment, the camera modules 216a, 216b, and 225 may include one or multiple lenses, an image sensor, and/or an image signal processor. In an embodiment, at least one of the camera modules 216a, 216b, and 225 may include two or more lenses (e.g., wide-angle and telephoto lenses) and image sensors, and may be arranged together on one surface of the first housing 210 and/or the second housing 220.

According to various embodiments, the sensor modules 217a, 217b, and 226 may generate a data value or an electrical signal corresponding to an internal operational state or an external environmental state of the electronic device 200.According to an embodiment, the sensor modules 217a, 217b, and 226 may include a first sensor module 217a disposed on the first surface 211 of the first housing 210, a second sensor module 217b disposed on the second surface 212 of the first housing 210, and/or a third sensor module 226 disposed on the fourth surface 222 of the second housing 220. In an embodiment, the sensor modules 217a, 217b, and 226 may include at least one of a gesture sensor, a grip sensor, a color sensor, an infrared (IR) sensor, an illuminance sensor, an ultrasonic sensor, an iris recognition sensor, or a distance detection sensor (e.g., a time of flight (TOF) sensor or a light detection and ranging (LiDAR)).

According to various embodiments, the electronic device 200 may further include an unillustrated sensor module, for example, at least one of an atmospheric sensor, a magnetic sensor, a biometric sensor, a temperature sensor, a humidity sensor, or a fingerprint recognition sensor. In an embodiment, the fingerprint recognition sensor may be disposed through at least one of the first side member 213 of the first housing 210 and/or the second side member 223 of the second housing 220.

According to various embodiments, the key input device 219 may be disposed to be exposed to the outside through the first side member 213 of the first housing 210. In an embodiment, the key input device 219 may be disposed to be exposed to the outside through the second side member 223 of the second housing 220. In an embodiment, the electronic device 200 may not include some or all of the key input device 219, and the unincluded key input device 219 may be implemented in another shape such as a soft key on the least one display 230 and 300. In another embodiment, the key input device 219 may be implemented by using a pressure sensor included in the at least one display 230 and 300.

According to various embodiments, the connector port 229 may include a connector (e.g., a USB connector or an IF module (an interface connector port module)) for transmitting or receiving data and/or power to and/or from an external electronic device. In an embodiment, the connector port 229 may perform a function of transmitting or receiving an audio signal to or from the external electronic device together, or may further include a separate connector port (e.g., an ear jack hole) for performing a function of transmitting or receiving an audio signal to or from the external electronic device.

According to various embodiments, at least one camera modules 216a and 225 of the camera modules 216a, 216b, and 225, at least one sensor module 217a and 226 of the sensor modules 217a, 217b, and 226, and/or an indicator may be arranged to be exposed through the at least one display 230 and 300. For example, the at least one camera modules 216a and 225, the at least one sensor module 217a and 226, and/or the indicator may be arranged under an activated area (a display area) of the at least one display 230 and 300 in a space in the at least one housing 210 and 220, and may be arranged to come into contact with an external environment through a transparent area or an opening that is perforated to a cover member (e.g., a window layer (not shown) of the first display 230 and/or the second rear cover 250). According to an embodiment, an area in which the at least one display 230 and 300 and the at least one camera module 216a and 225 face each other may be formed as a transmission area having a predetermined transmission ratio, as a part of an area in which a content is displayed. According to an embodiment, the transmission area may be formed to have a transmission ratio in the range of about 5% to about 20%. The transmission area may include an area overlapping with an effective area (e.g., an angle of view area) of the at least one camera module 216a and 225, wherein an image is formed on the image sensor in the effective area, and light for generating an image passes through the effective area. For example, the transmission area of the display 230 and 300 may include an area in which the density of a pixel is lower than that in a surrounding area. For example, the transmission area may be replaced with an opening. For example, the at least one camera module 216a and 225 may include an under-display camera (UDC) or an under-panel camera (UPC). In another embodiment, some camera modules or sensor modules 271a and 226 may be arranged to perform functions thereof without being visually exposed through the display. For example, an area facing the sensor module 217a and 226 and/or the camera module 216a and 225 arranged under the display 230 and 300 (e.g., a display panel) corresponds to an under-display camera (UDC) structure, and a perforated opening is not necessarily required.

FIG. 3 is an exploded perspective view of the electronic device according to various embodiments of the disclosure.

Referring to FIG. 3, an electronic device 200 may include a first display 230 (e.g., a flexible display), a second display 300, one or more hinge apparatuses 400-1 and 400-2, a pair of support members 261 and 262, one or more substrates 270 (e.g., a printed circuit board (PCB)), a first housing 210, a second housing 220, a first rear surface cover 240, and/or a second rear surface cover 250.

According to various embodiments, the first display 230 may include a display panel 430 (e.g., a flexible display panel) and a support plate 450 disposed below the display panel 430. In an embodiment, the first display 230 may include a reinforcing plate 462 disposed below the support plate 450. In some embodiments, the reinforcing plate 462 may be omitted. In an embodiment, the display panel 430 may include a first panel area 430a corresponding to a first area (e.g., the first area 230a in FIG. 1A) of the first display 230, a second panel area 430b extending from the first panel area 430a and corresponding to a second area (e.g., the second area 230b in FIG. 1) of the first display 230, and a third panel area 430c interconnecting the first panel area 430a and the second panel area 430b and corresponding to a folding area (e.g., the folding area 230c in FIG. 1A) of the first display 230. In an embodiment, the support plate 450 is disposed between the display panel 430 and a pair of support members 261 and 262 and may be configured to have a material and a shape to provide a flat support structure for the first panel area 430a and the second panel area 430b and a bendable structure for helping bendability of the third panel area 430c. In an embodiment, the support plate 450 may be formed of a conductive material (e.g., metal) or a non-conductive material (e.g., polymer or fiber reinforced plastics (FRP)). In an embodiment, the reinforcing plate 462 may include, between the support plate 450 and a pair of support members 261 and 262, a first reinforcing plate 4621 disposed to correspond to the first panel area 430a and at least a portion of the third panel area 430c, and a second reinforcing plate 4622 disposed to correspond to the second panel area 430b and at least a portion of the third panel area 430c. In an embodiment, the reinforcing plate 462 is formed of a metal material (e.g., SUS) to help reinforce a ground connection structure and rigidity for the first display 230. In some embodiments, the electronic device 200 may include a digitizer disposed below the support plate 450 in replacement for the support plate 462 or added between the support plate 450 and the reinforcing plate 462.

According to various embodiments, the second display 300 may be disposed in a space between the second housing 220 and the second rear surface cover 250. In an embodiment, the second display 300 may be disposed in the space between the second housing 220 and the second rear surface cover 250 to be visible from the outside through substantially the entire area of the second rear surface cover 250.

According to various embodiments, at least a portion of the first support member 261 may be coupled to the second support member 262 to be foldable via the one or more hinge apparatuses 400-1 and 400-2. In an embodiment, the electronic device 200 may include one or more wiring members 263 (e.g., a flexible printed circuit board (FPCB)) extending from at least a portion of the first support member 261 to a portion of the second support member 262 across the one or more hinge apparatuses 400-1 and 400-2. In an embodiment, the first support member 261 may extend from a first side surface member 213 or may be disposed in a manner of being structurally coupled with the first side surface member 213. In an embodiment, the electronic device 200 may include a first space (e.g., the first space 2101 of FIG. 1A) provided by the first support member 261 and the first rear surface cover 240. In an embodiment, the first housing 210 (e.g., a first housing structure) may be configured through the assembly of the first side surface member 213, the first support member 261, and the first rear surface cover 240. In an embodiment, the second support member 262 may extend from a second side surface member 223 or may be disposed in a manner of being structurally coupled with the second side surface member 223. In an embodiment, the electronic device 200 may include a second space (e.g., the second space 2201 of FIG. 1A) provided by the second support member 262 and the second rear surface cover 250. In an embodiment, the second housing 220 (e.g., a second housing structure) may be configured through the assembly of the second side surface member 223, the second support member 262, and the second rear surface cover 250. In an embodiment, the one or more wiring members 263 and/or the one or more hinge apparatuses 400-1 and 400-2 may be disposed to be at least partially supported by at least a portion of the pair of support members 261 and 262. In an embodiment, the one or more wiring members 263 may be disposed to extend from the first support member 261 to the second support member 262 across a folding axis F. In an embodiment, the one or more wiring members 263 may be disposed to have a length in a direction (e.g., the x-axis direction) substantially perpendicular to the folding axis (e.g., the y-axis or the folding axis F of FIG. 1A).

According to various embodiments, the one or more substrates 270 may include a first substrate 271 disposed in the first space 2101 and a second substrate 272 disposed in the second space 2201. In an embodiment, the first substrate 271 and the second substrate 272 may include a plurality of electronic components arranged to implement various functions of the electronic device 200. In an embodiment, the first substrate 271 and the second substrate 272 may be electrically connected to each other via the one or more wiring members 263.

According to various embodiments, the electronic device 200 may include one or more batteries 291 and 292. In an embodiment, the one or more batteries 291 and 292 may include a first battery 291 disposed in the first space 2101 of the first housing 210 and electrically connected to the first substrate 271 and a second battery disposed in the second space 2201 of the second housing 220 and electrically connected to the second substrate 272. In an embodiment, the first support member 261 and the second support member 262 may further include one or more swelling holes for the first battery 291 and the second battery 292.

According to various embodiments, the first housing 210 may include a first rotation support surface 214, and the second housing 220 may include a second rotation support surface 224, which corresponds to the first rotation support surface 214. In an embodiment, the first rotation support surface 214 and the second rotation support surface 224 may each include a curved surface corresponding to (naturally connected to) the curved outer surface of the hinge housing 310. In an embodiment, when the electronic device 200 is in the unfolded state, the first rotation support surface 214 and the second rotation support surface 224 may cover the hinge housing 310 such that a hinge housing 310 cannot be exposed to the rear surface of the electronic device 200 or can be only partially exposed to the rear surface of the electronic device 200. In an embodiment, when the electronic device 200 is in the folded state, the first rotation support surface 214 and the second rotation support surface 224 may rotate along the curved outer surface of the hinge housing 310 to at least partially expose the hinge housing 310 to the rear surface of the electronic device 200.

According to various embodiments, the electronic device 200 may include one or more antennas 276 disposed in the first space 2201. In an embodiment, the one or more antennas 276 may be disposed on the first battery 291 and the first rear surface cover 240 in the first space 2201. In an embodiment, the one or more antennas 276 may include, for example, a near-field communication (NFC) antenna, a wireless charging antenna, and/or a magnetic secure transmission (MST) antenna. In an embodiment, the one or more antennas 276 may execute, for example, short-range communication with an external device or wireless transmission/reception of power required for charging. In some embodiments, antenna structures may be configured by at least a portion of the first side surface member 213 or the second side surface member 223 and/or a portion of the first support member 261 and the second support member 262 or a combination thereof.

According to various embodiments, the electronic device 200 may further include one or more electronic component assemblies 274 and 275 and/or additional support members 263 and 273 disposed in a first space (e.g., the first space 2101 of FIG. 1A) and/or a second space (e.g., the second space 2201 of FIG. 1A). For example, the one or more electronic component assemblies may include an interface connector port assembly 274 or a speaker assembly 275.

According to various embodiments, the electronic device 200 may include a first waterproof member WP1 disposed between the first reinforcing plate 4621 and the first support member 261 and a second waterproof member WP2 disposed between the second reinforcing plate 4622 and the second support member 262. In an embodiment, the first waterproof member WP1 may provide at least one first waterproof space between the first reinforcing plate 4621 and the first support member 261. In an embodiment, the at least one first waterproof space may accommodate an area corresponding to at least one electronic component (e.g., a camera module or a sensor module) disposed to be supported by the first support member 261. In an embodiment, the second waterproof member WP2 may provide a second waterproof space between the second reinforcing plate 4622 and the second support member 262. In an embodiment, the second waterproof space may accommodate at least a portion of the bending portion folded to the rear surface of the first display 230. For example, the second waterproof space may be disposed to surround at least a portion of the bending portion extending from the display panel 430 of the first display 230 and folded to the rear surface. Therefore, a control circuit (e.g., a display driver IC (DDI)) and a plurality of electrical elements disposed on the bending portion 432 may be protected from external moisture and/or foreign substances by being disposed in the second waterproof space.

According to various embodiments, the electronic device 200 may include a waterproof tape 241 disposed between the first rear surface cover 240 and the first housing 210. In an embodiment, the electronic device 200 may include a bonding member 251 disposed between the second rear surface cover 250 and the second housing 220. In some embodiments, the bonding member 251 may be disposed between the second display 300 and the second housing 220. In some embodiments, the waterproof tape 241 may be replaced with the bonding member 251, and the bonding member 251 may be replaced with the waterproof tape 241.

According to various embodiments, the one or more hinge apparatuses 400-1 and 400-2 may include a first hinge apparatus 400-1 disposed at one end in a direction parallel to the folding axis F and a second hinge apparatus 400-1 disposed at the other end. In an embodiment, the first hinge apparatus 400-1 and the second hinge apparatus 400-2 may have substantially the same configuration. In an embodiment, the electronic device 200 may include a connection module 400-3 disposed between the first hinge apparatus 400-1 and the second hinge apparatus 400-2. In an embodiment, the connection module 400-3 may be disposed through a combination of one or more gears and/or a combination of one or more links. In some embodiments, the connection module 400-3 may be replaced with the first hinge apparatus 400-1. In some embodiments, the one or more hinge apparatuses 400-1 and 400-2 may be disposed at one location or three or more locations at predetermined intervals along a direction parallel to the folding axis F. In an embodiment, the electronic device 200 may include a first hinge plate 311 and a second hinge plate 312 connected via the one or more hinge apparatuses 400-1 and 400-2. In an embodiment, in the unfolded state, the first hinge plate 311 may form the same plane as the first housing 210, and, in the unfolded state, the second hinge plate 312 may form the same plane as the second housing 220.

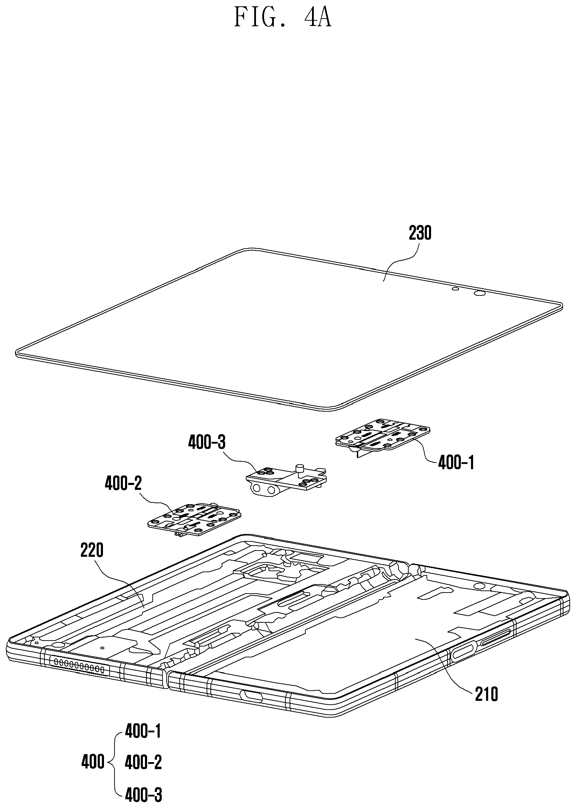

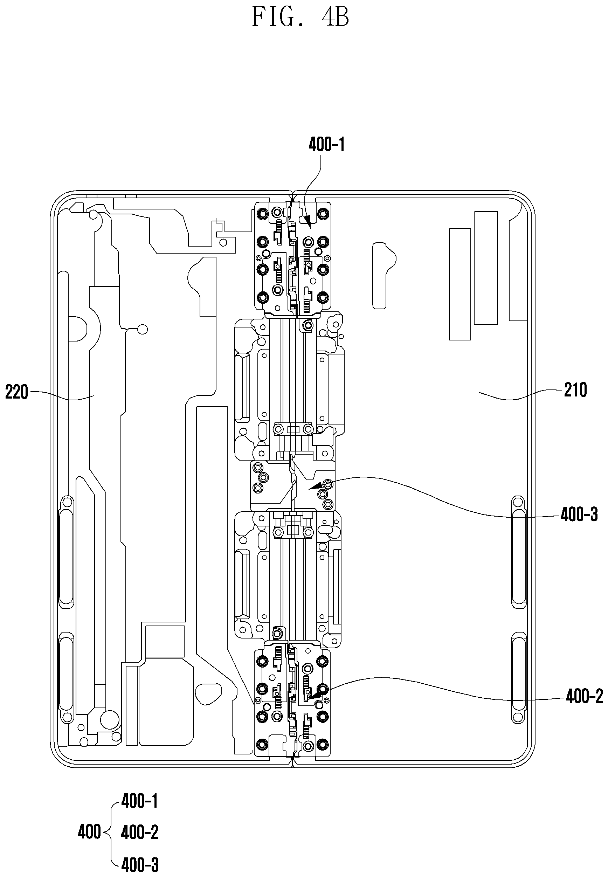

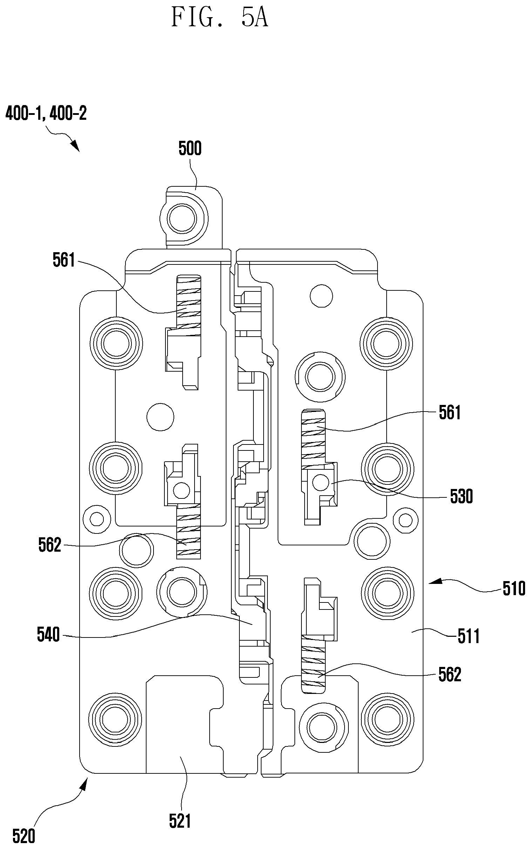

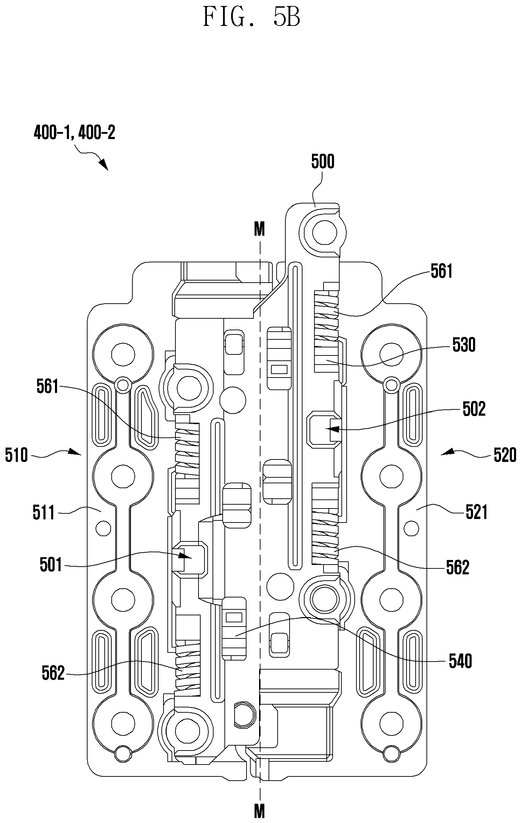

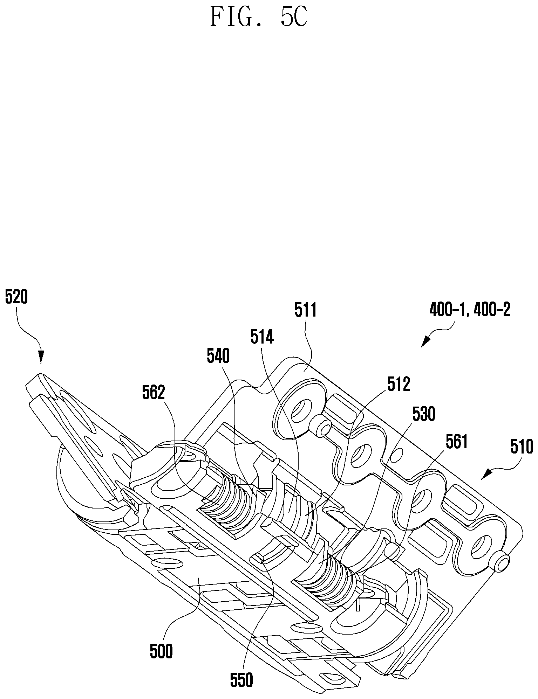

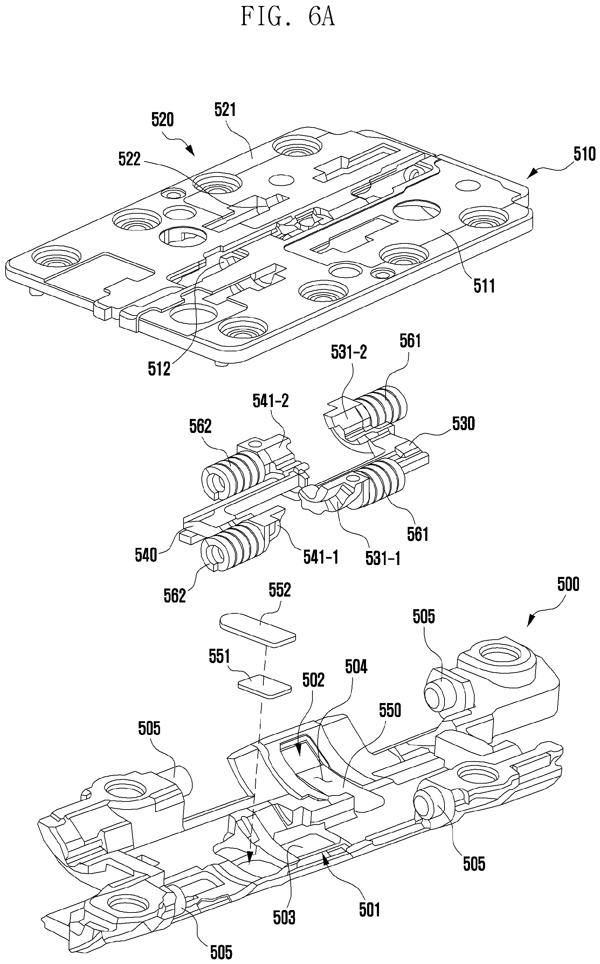

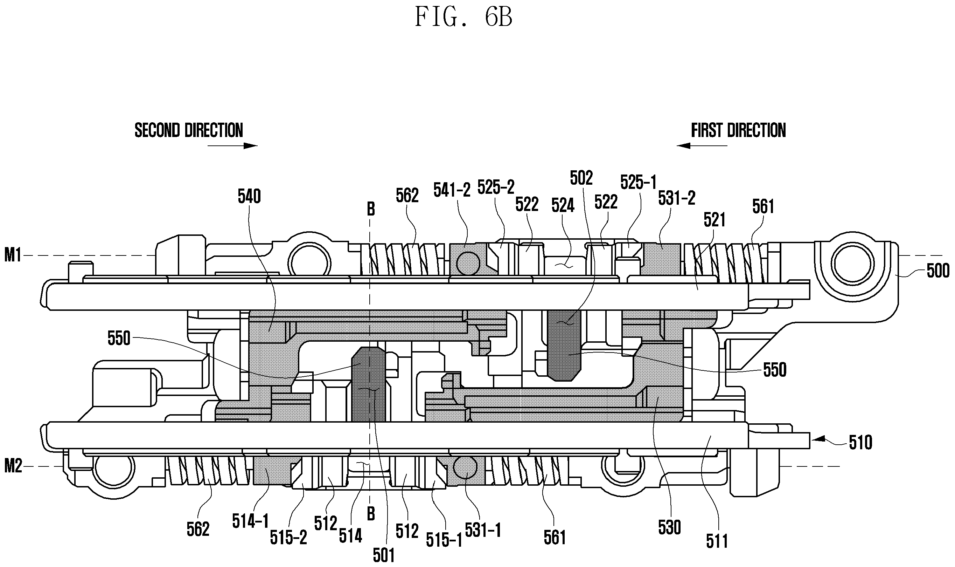

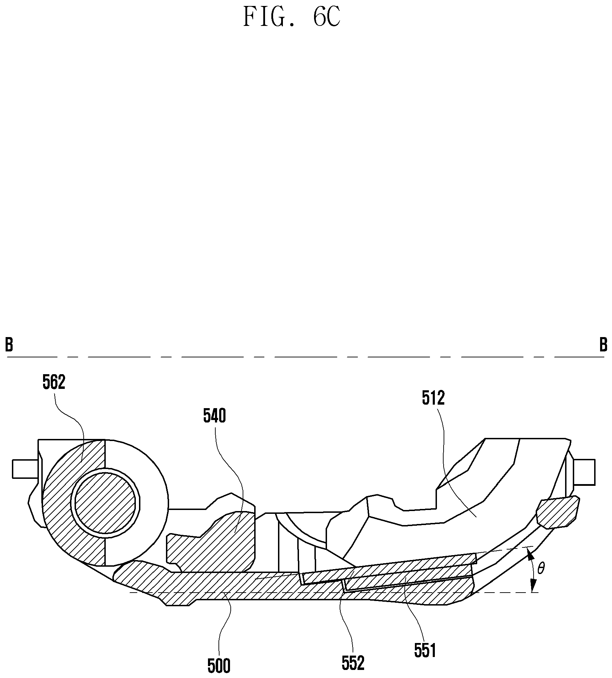

FIG. 4A is an exploded perspective view of the electronic device according to various embodiments of the disclosure. FIG. 4B is a view illustrating a state in which hinge apparatuses according to an embodiment of the disclosure are assembled to the electronic device. FIG. 5A is a front view of a hinge apparatus according to an embodiment of the disclosure. FIG. 5B is a rear view of the hinge apparatus according to an embodiment of the disclosure. FIG. 5C is a perspective view of the hinge apparatus according to an embodiment of the disclosure. FIG. 6A is an exploded perspective view of the hinge apparatus according to an embodiment of the disclosure. FIG. 6B is a front view of the hinge apparatus according to an embodiment of the disclosure in the folded state. FIG. 6C is a cross-sectional view of the hinge apparatus according to an embodiment of the disclosure taken along line B-B of FIG. 6B.

According to an embodiment, as illustrated in FIGS. 4A and 4B, the first housing 210 and the second housing 220 are connected to each other by a hinge structure 400 to be foldable. The hinge structure 400 may be disposed between the first housing 210 and the second housing 220 to allow the first housing 210 and the second housing 220 to be folded.

According to an embodiment, as illustrated in FIGS. 4A and 4B, a plurality of hinge structures 400 may be provided and disposed between the first housing 210 and the second housing 220. In an embodiment, the electronic device 200 may have a structure that is assembled in the order of the first display 230, the hinge structure 400, and the housings 210 and 220. In an embodiment, the hinge structure 400 includes a first hinge apparatus 400-1, a second hinge apparatus 400-2, and a connection module 400-3. The first housing 210 and the second housing 220 are foldable or unfoldable via the first hinge apparatus 400-1, the second hinge apparatus 400-2, and the connection module 400-3. However, the electronic device 200 disclosed herein is not limited to the number of hinge structures 400. The number of hinge structures 400 included in the electronic device 200 may be variously changed in consideration of the size and load capacity of the hinge structures 400.

Hereinafter, the first hinge apparatus 400-1 and the second hinge apparatus 400-2 of the hinge structure 400 will be described. In the following description, the first hinge apparatus 400-1 will be used to describe the hinge apparatuses 400-1 and 400-2. The second hinge apparatus 400-2 has a configuration corresponding to the first hinge apparatus 400-1, and in the following description, the description of the "first hinge apparatus 400-1" is equally applicable to "the second hinge apparatus 400-2". Similarly, a description for components having the same configuration among the components of the first hinge apparatus 400-1 will be replaced with a description for one component without repeated description. For example, for a rotator of the first hinge apparatus 400-1, a description for the first rotator 510 will be used. The second rotator 520 is a component corresponding to the first rotator 510, and the description of the "first rotator 510" is equally applicable to the "second rotator 520".

According to an embodiment, as illustrated in FIGS. 5A to 6B, the first hinge apparatus 400-1 may include a bracket 500, a first rotator 510, a second rotator 520, a first cam slide 530, a second cam slide 540, dampers 550, and elastic members 561 and 562. The above-mentioned components of the first hinge apparatus 400-1 are merely examples, and at least one of the above-mentioned components may be omitted as necessary, and it is also possible to configure the first hinge apparatus 400-1 by adding other components.

According to an embodiment, as illustrated in FIGS. 5A to 5C, the bracket 500 may be a body of the first hinge apparatus 400-1 to which components of the first hinge apparatus 400-1 can be coupled to each other. The components of the first hinge apparatus 400-1 may be disposed around the bracket 500 and may be coupled to each other or installed to be interlocked. In an embodiment, the first rotator 510 and the second rotator 520 may be installed on the bracket 500 and may rotate about the center M of the bracket 500. The first cam slide 530 and the second cam slide 540 may be disposed on the bracket 500 to be interlocked with the first rotator 510 and the second rotator 520. In an embodiment, the center M of the bracket 500 may be the center of rotation of the first hinge apparatus 400-1. Therefore, the bracket 500 may be disposed in the first housing 210 and the second housing 220 such that the center M of the bracket 500 and the center of rotation of the electronic device 200 (e.g., the axis F in FIG. 1) coincide with each other. In an embodiment, the bracket 500 may be formed of various materials. For example, the bracket 500 may be formed of a metal material or a synthetic resin material. In an embodiment, the bracket 500 may be formed of a highly rigid material to stably support various components of the first hinge apparatus 400-1.

According to an embodiment, as illustrated in FIGS. 5A to 6B, the bracket 500 includes a first coupling portion 501 and a second coupling portion 502. The first coupling portion 501 and the second coupling portion 502 may be spaced apart from each other. For example, the first coupling portion 501 may be disposed in one direction with respect to the center M of the bracket 500, and the second coupling portion 502 may be disposed in the opposite direction to the one direction with respect to the center M of the bracket 500. In an embodiment, the first coupling portion 501 may be a portion into which a first rotating portion 512 of the first rotator 510 is inserted. The first rotating portion 512 is a portion of the first rotator 510 and may be a portion inserted into the first coupling portion 501. The second coupling portion 502 may be a portion into which a second rotating portion 522 of the second rotator 520 is inserted. The second rotating portion 522 is a portion of the second rotator 520 and may be a portion inserted into the second coupling portion 502. The first coupling portion 501 may guide the rotation of the first rotating portion 512 relative to the center M of the bracket 500. For example, the first rotating portion 512 may be fastened to the first coupling portion 501 and may rotate about the center M of the bracket 500. Similarly, the second coupling portion 502 may guide the rotation of the second rotating portion 522 relative to the center M of the bracket 500. For example, the second rotating portion 522 may be fastened to the second coupling portion 502 and may rotate about the center M of the bracket 500. In some embodiments, the first coupling portion 501 and the second coupling portion 502 may each include a rail (not illustrated). The first rotating portion 512 may be fastened to the rail provided on the first coupling portion 501 and may rotate about the center M of the bracket 500. Similarly, the second rotating portion 522 may be fastened to the rail provided on the second coupling portion 502 and may rotate about the center M of the bracket 500.

According to an embodiment, as illustrated in FIG. 6A, the bracket 500 may include a first seating groove 503 and a second seating groove 504 in which dampers 550 to be described later are disposed, respectively. The first seating groove 503 may be provided in the first coupling portion 501 on which the first rotating portion 512 is seated. The second seating groove 504 may be provided in the second coupling portion 502 on which the second rotating portion 522 is seated. The dampers 550 may be seated in the first seating groove 503 and the second seating groove 504 to come into contact with the first rotating portion 512 and the second rotating portion 522, respectively. The relationship between the dampers 550 and the first and second rotating portions 512 and 522 of the first and second rotators 510 and 520 will be described later.

According to an embodiment, as illustrated in FIGS. 5A to 6B, the first rotator 510 may include a first plate 511 and a first rotating portion 512. The second rotator 520 may include a second plate 521 and a second rotating portion 522. In an embodiment, the first plate 511 and the second plate 521 may support the first display 230. The first display 230 may include a first area 230a, a second area 230b, and a third area 230c, which is a folding area located between the first area 230a and the second area 230b. The first area 230a, the second area 230b, and the third area 230c are conceptually divided areas of the first display 230 for description, and may not be visually separated areas. The first plate 511 may support the first area 230a of the first display 230. The second plate 521 may support the second area 230b of the first display 230. By rotating the first plate 511 and the second plate 521 relative to the bracket 500, the first area 230a and the second area 230b of the first display 230 may also rotate relative to the bracket 500. When the first area 230a and the second area 230b of the first display 230 rotate, the first area 230a and the second area 230b may be bent about the third area 230c.

In an embodiment, the first rotating portion 512 may be coupled to the first plate 511. For example, the first rotating portion 512 may be configured integrally with the first plate 511. In addition, the first rotating portion 512 may be coupled to the first plate 511 through various coupling methods (e.g., bolting, riveting, bonding by an adhesive, and welding). Similarly, the second rotating portion 522 may be coupled to the second plate 521. For example, the second rotating portion 522 may be configured integrally with the second plate 521. In addition, the second rotating portion 522 may be coupled to the second plate 521 through various coupling methods.

In an embodiment, by fastening the first rotating portion 512 of the first rotator 510 to be rotatable relative to the bracket 500, the first plate 511 is rotatable relative to the bracket 500. By fastening the second rotating portion 522 of the second rotator 520 to be rotatable relative to the bracket 500, the second plate 521 is rotatable relative to the bracket 500. The rotation of the first plate 511 relative to the bracket 500 may be performed by using the center of the first rotating portion 512 as a rotation center M1. Hereinafter, the rotation center of the first plate 511 will be referred to as a first rotation center M1. The rotation of the second plate 521 relative to the bracket 500 may be performed by using the center of the second rotating portion 522 as a rotation center M2. Hereinafter, the rotation center of the second plate 521 will be referred to as a second rotation center.

According to an embodiment, a stop operation and a free-stop operation may be required to increase usability of the electronic device 200. The stop operation may refer to an operation in which the electronic device 200 maintains the state in the fully folded or in the fully unfolded state. The free-stop operation may mean an operation to maintain the state of the electronic device 200 when an external force of a certain level or more does not act while the electronic device 200 is switched from the folded state to the unfolded state. The stop operation and the free-stop operation may be implemented through a cam structure provided in the rotating portion of the rotator and a cam portion of a cam slide configured in a shape corresponding to the cam structure and fastened to the cam structure.

According to an embodiment, as illustrated in FIGS. 5A to 6B, a first cam slide 530 and a second cam slide 540 may be disposed on the bracket 500. Referring to FIGS. 5A to 5C, the first cam slide 530 and the second cam slide 540 may be fastened to the first rotating portion 512 of the first rotator 510 and the second rotating portion 522 of the second rotator 520, respectively. According to an embodiment, the first rotating portion 512 may include a first cam structure 515. The first cam structure 515 may include a (1-1)^{th} cam structure 515-1 provided on the first surface of the first rotating portion 512 and a (1-2)^{th} cam structure 515-2 provided on the second surface opposite to the first surface. The second cam structure 525 may include a (2-1)^{th} cam structure 525-1 provided on the first surface of the second rotating portion 522 and a (2-2)^{th} cam structure 525-2 provided on the second surface opposite to the first surface. The first cam slide 530 may include a (1-1)^{th} cam portion 531-1 engaged with the (1-1)^{th} cam structure 515-1 provided on the first surface of the first rotating portion 512 and a (1-2)^{th} cam portion 531-2 engaged with the (2-1)^{th} cam structure 525-1 provided on the first surface of the second rotating portion 522. The second cam slide 540 may include a (2-1)^{th} cam portion 541-1 engaged with a (1-2)^{th} cam portion 531-2 provided on the second surface of the first rotating portion 512 and a (2-2)^{th} cam portion 541-2 engaged with the (2-2)^{th} cam portion provided on the second surface of the second rotating portion 522. Therefore, the first cam structure 515 of the first rotating portion 512 and the second cam structure 525 of the second rotating portion 522 may implement a stop operation and a free-stop operation through the engagement between the first cam portion 531 of the first cam slide 530 and the second cam portion 541 of the second cam slide 540.

According to an embodiment, as illustrated in FIGS. 6A and 6B, the first hinge apparatus 400-1 may include a plurality of elastic members 561 and 562. The plurality of elastic members 561 and 562 may be disposed on the bracket 500 to press the first cam slide 530 and the second cam slide 540 in opposite directions. Referring to FIGS. 6A and 6B, the first elastic member 561 may press the first cam slide 530 in a first direction (e.g., the first direction of FIG. 6B) such that the (1-1)^{th} cam structure 515-1 of the first rotating portion 512 and the (1-1)^{th} cam portion 531-1 of the first cam slide 530 can be engaged with the (2-1)^{th} cam structure 525-1 of the second rotating portion 522 and the (1-2)^{th} cam portion 531-2 of the first cam slide 530. The second elastic member 562 may press the second cam slide 540 in a second direction opposite to the first direction such that the (1-2)^{th} cam structure 515-2 of the first rotating portion 512 and the (2-1)^{th} cam portion 541-1 of the second cam slide 540 can be engaged with the (2-2)^{th} cam structure 525-2 of the second rotating portion 522 and the (2-2)^{th} cam portion 541-2 of the second cam slide 540. Accordingly, as the cam structures 515 and 525 provided on the first rotating portion 512 and the second rotating portion 522 are engaged with the cam portions 531 and 541 provided on the first cam slide 530 and the second cam slide 540, the electronic device 200 is capable of performing a stop operation in the folded state or the unfolded state and a free-stop operation in an intermediate state. Hereinafter, for convenience of description, the operation in which the first cam structure 515 of the first rotating portion 512 and the second cam structure 525 of the second rotating portion 522 are engaged with the first cam portion 531 of the first cam slide 530 and the second camp portion 541 of the second slide 540 will be briefly expressed as "engagement between the cam structures 515 and 525 of the rotating portions 512 and 522 and the cam portions 531 and 541 of the cam slides 530 and 540.

According to an embodiment, as illustrated in FIG. 6A, the bracket 500 may include a plurality of separation prevention pieces 505. Each of the separation prevention pieces 505 may have a shape protruding from one of the surfaces of the bracket 500 that are in contact with a plurality of elastic members 561 and 562. Each of the elastic members 561 and 562 may be prevented from being separated from the bracket 500 by having one end inserted into a corresponding one of the separation preventing pieces 505. In an embodiment, one end of the first elastic member 561 may be inserted into a corresponding one of the separation prevention pieces 505 and the other end opposite to the one end may press the first cam slide 530. One end of the second elastic member 562 may be inserted into a corresponding one of the separation prevention pieces 505 and the other end opposite to the one end may press the second cam slide 540. Accordingly, by pressing the cam slides 530 and 540, the plurality of elastic members 561 and 562 may be prevented from being separated from the bracket 500 by the separation prevention pieces 505 due to a compressive force.

In an embodiment, during the folding or unfolding operation, the first hinge apparatus 400-1 may generate noise or vibration due to a collision between components or a step difference. As described above, the first hinge apparatus 400-1 may be configured such that the cam structures 515 and 525 provided on the rotating portions 512 and 522 and the cam portions 531 and 541 provided on the cam slides 530 and 540 are engaged with each other. In the folding or unfolding operation of the electronic device 200, continuous contact occurs between the cam structures 515 and 525 of the rotating portions 512 and 522 and the cam portions 531 and 541 of the cam slides 530 and 540. When the folding or unfolding operation of the device 200 is caused with a strong force, a collision between the cam structures 515 and 525 of the rotating portions 512 and 522 and the cam portions 531 and 541 of the cam slides 530 and 540 may generate noise and/or vibration. For example, when a user rapidly folds or unfolds the electronic device 200, a collision may occur between the cam structures 515 and 525 and the cam portions 531 and 541, thereby generating noise and/or vibration. In addition, when the electronic device 200 is dropped, a collision may be applied to the hinge apparatuses 400-1 and 400-2, thereby generating a gap or a step difference between the cam structures 515 and 525 and the cam portions 531 and 541. In this case, noise and/or vibration may be generated between the cam structures 515 and 525 and the cam portions 531 and 541 in response to the folding or unfolding operation of the electronic device 200. The noise and vibration generated from the hinge apparatuses 400-1 and 400-2 of the electronic device 200 may deteriorate the operation feeling of the electronic device 200, causing discomfort to consumers. According to an embodiment disclosed herein, each of the hinge apparatuses 400-1 and 400-2 includes a damper 550. The dampers 550 may alleviate noise or vibration generated from the hinge apparatuses 400-1 and 400-2. This will be explained in detail below.

According to an embodiment, as illustrated in FIGS. 6A and 6B, the dampers 550 is disposed on the bracket 500. The dampers 550 is disposed in the first coupling portion 501 and the second coupling portion 502 to come into contact with the first rotating portion 512 of the first rotator 510 and the second rotating portion 522 of the second rotator 520, respectively. However, a plurality of dampers 550 may not be limited to being disposed in the first coupling portion 501 and the second coupling portion 502. The plurality of dampers 550 is disposed on the bracket 500 within various ranges to come into contact with the first rotating portion 512 and the second rotating portion 522, respectively. In the above description, it has been described that two or more dampers 550 are disposed in the bracket 500, but this may not limit the number of dampers 550. In an embodiment, only one damper 550 may be disposed on the bracket 500. For example, the damper 550 may be disposed on one of the first coupling portion 501 and the second coupling portion 502. In some embodiments, two or more dampers 550 may be disposed on the bracket 500. Hereinafter, for convenience of description, description will be made on the premise that dampers 550 are disposed on the first coupling portion 501 and the second coupling portion 502, respectively.

In an embodiment, referring to FIGS. 6A and 6B, the dampers 550 may be seated in the first seating groove 503 provided in the first coupling portion 501 and the second seating groove 504 provided in the second coupling portion 502 to come into contact with the first rotating portion 512 and the second rotating portion 522, respectively. The dampers 550 may alleviate vibration or noise caused by contact between the cam structures 515 and 525 of the rotating portions 512 and 522 and the cam portions 531 and 541 of the cam slides 530 and 540 according to the folding or unfolding operation of the electronic device 200.

According to an embodiment, as illustrated in FIG. 6A, each of the dampers 550 may include a buffer member 551 and a pressing plate 552. The pressing plate 552 may be configured to come into contact with the rotating portion 512 or 522. The buffer member 551 may be configured to buffer the impact of the rotating portion 512 or 522 transmitted through the pressing plate 552. Thereby, the buffer member 551 may reduce the vibration or noise generated from the rotational motion from the rotating portion 512 or 522. The buffer members 551 may be disposed in the first seating groove 503 located inside the first coupling portion 501 of the bracket 500 and the second seating groove 504 located inside the second coupling portion 502, respectively. The pressing plates 552 may be disposed in the first seating groove 503 and the second seating groove 504 to cover the buffer members 551, respectively, and may be brought into contact with the first rotating portion 512 and the second rotating portion 522, respectively. The pressing plate 552 may alleviate the impact with the rotation portion 512 or 522 as the pressing plate 552 contacts with the rotating portion 512 or 522. Furthermore, the pressing plate 552 may enhance the durability of the buffer member 551 through the numerous times of rotational motion of the electronic device 200 by protecting the buffer member 551 from the direct contact with the rotating portion 512 or 522. In an embodiment, the buffer members 551 may be formed of a shock absorbing material such as rubber, urethane, or silicone to be capable of buffering the impact of the rotating portions 512 and 522 transmitted through the pressing plates 552. The pressing plates 552 may be formed of a highly rigid material to stably support the rotating portions 512 and 522. For example, the pressing plates 552 may be made of a metal material and/or a non-metal material. Here, the metal material may include an alloy of aluminum, stainless steel (STS, SUS), iron, magnesium, titanium, or the like, and the non-metal material may include a synthetic resin, ceramic, or engineering plastic. In an embodiment, the buffer members 551 and the pressing plates 552 may be coupled to the bracket 500 in various ways. For example, the buffer members 551 may be coupled to the bracket 500 through various methods such as bonding by an adhesive, thermal fusion, bonding by epoxy, and UV curing. When being made of a metal material, the pressing plates 552 may be fixed to the bracket 500 through soldering. When being made of a non-metal material, the pressing plates 552 may be fixed to the bracket 500 in various ways such as bonding by an adhesive, thermal fusion, bonding by epoxy, and UV curing.

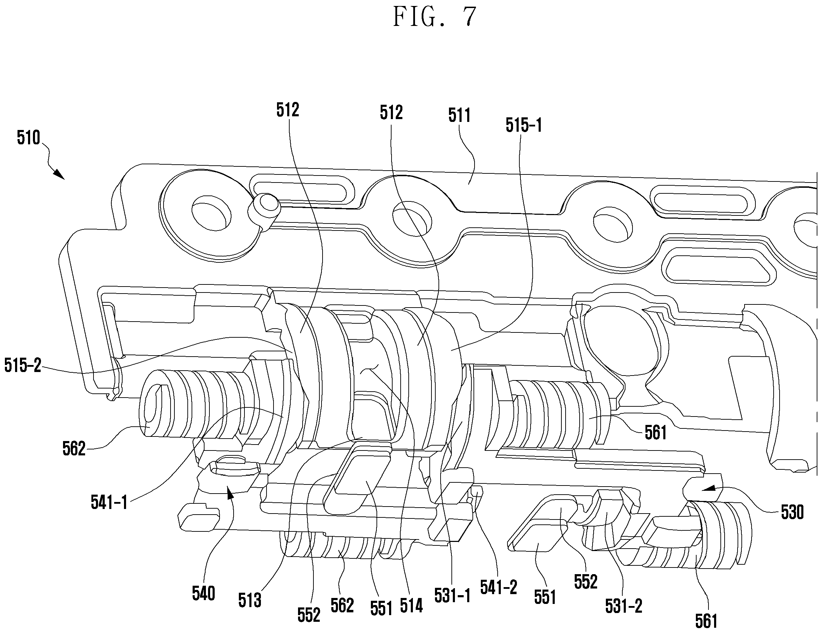

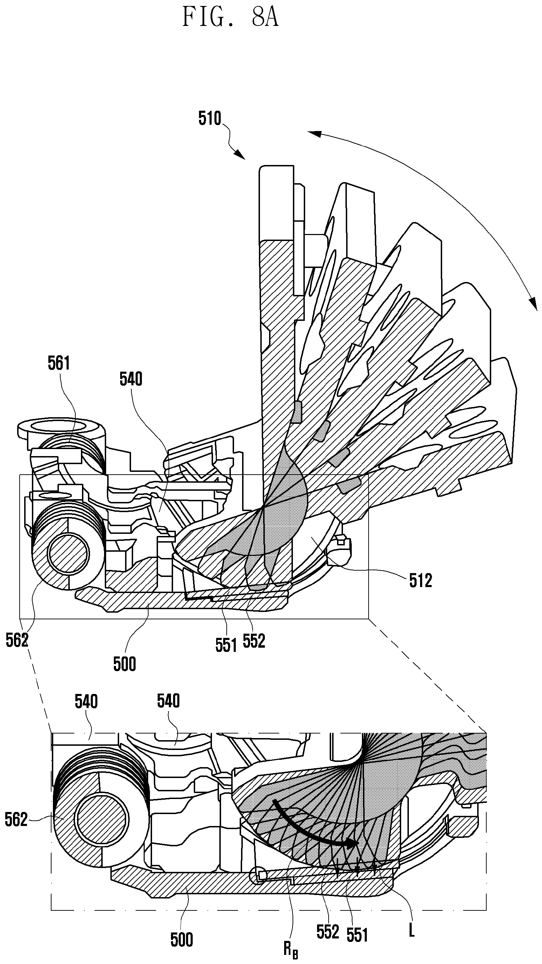

According to an embodiment, as illustrated in FIG. 6C, the plurality of dampers 550 may be seated on the bracket 500 to form a predetermined angle θ with respect to one surface of the bracket 500. For example, the plurality of dampers 550 may form a predetermined angle θ with respect to one surface of the bracket to respectively come into contact with the first rotating portion 512 and the second rotating portion 522 in a predetermined section L of the first rotating portion 512 of the first rotator 510 (e.g., the predetermined section L of FIG. 8A) and a predetermined section of the second rotating portion 522 of the second rotator 520. For example, referring to FIG. 7 to be described later, the first rotating portion 512 may include a first contact portion 513. The first rotating portion 512 may come into contact with the damper 550 via the first contact portion 513. As the first contact portion 513 is configured to come into contact with the damper 550 in a predetermined section L depending on the degree of rotation of the first rotator 510 relative to the bracket 500, it enables the damper 550 to absorb the noise generated through the rotating motion from the first rotator 510. The second rotating portion 522 may include the same configuration as the first contact portion 513. As the second contact portion 523 is configured to come into contact with the damper 550 depending on the degree of rotation of the second rotator 520 relative to the bracket 500, it enables the damper 550 to absorb the noise generated through the rotating motion from the second rotator 520. The damper 550 may form a predetermined angle with respect to one surface of the bracket 500 to come into contact with the first contact portion 513 of the first rotating portion 512. In an embodiment, the plurality of dampers 550 may form an angle θ between about 5 degrees and 10 degrees with respect to one surface of the bracket 500 to come into contact with the first rotating portion 512 and the second rotating portion 522, respectively. In addition, the plurality of dampers 550 may form various angles θ with one surface of the bracket 500 to come into contact with the first rotating portion 512 and the second rotating portion 522, respectively. The damper 550 disposed on the bracket 500 to form a predetermined angle relative to one surface of the bracket 500 and comes into contact with at least one of the first rotating portion 512 and the second rotating portion 522 enables the effective impact absorption from the at least one of the first rotating portion 512 or the second rotating portion 522.

In an embodiment, the first seating groove 503 and the second seating groove 504 may form a predetermined angle θ with respect to one surface of the bracket 500. The buffer member 551 and the pressing plate 552 may be sequentially disposed respectively in the first seating groove 503 and the second seating groove 504 to form a predetermined angle θ with respect to one surface of the bracket 500. Accordingly, the first rotating portion 512 and the second rotating portion 522 may come into contact with the damper 550 in a predetermined section L (e.g., the predetermined section L in FIG. 8A).

FIG. 7 is a view for describing a contact position between a rotating portion of a rotator and a damper 550 according to an embodiment of the disclosure. FIGS. 8A to 8D are views illustrating the degree of contact of the rotator with the damper 550 depending on the rotational state of the rotator according to an embodiment of the disclosure.

According to an embodiment, friction may be generated between a plurality of dampers 550 and the first rotating portion 512 and the second rotating portion 522 as the electronic device 200 is being folded or unfolded. In the first hinge apparatus 400-1, the operation feeling may be impaired through the friction generated from the plurality of dampers 550 and each of the first rotating portion 512 and the second rotating portion 522. Therefore, the first rotating portion 512 and the second rotating portion 522 may be configured to come into contact with the dampers 550 only in a predetermined section L (e.g., the predetermined section L in FIG. 8A) so that the operation feeling of the first hinge apparatus 400-1 is not impaired. Hereinafter, the first rotating portion 512 and the second rotating portion 522 will be described with reference to the first rotating portion 512. The second rotating portion 522 corresponds to the first rotating portion 512, and the description of the "first rotating portion 512" may be replaced with the description of the "second rotating portion 522".

According to an embodiment, as illustrated in FIG. 7, the first rotating portion 512 of the first rotator 510 may include a first contact portion 513 and a first groove 514. The first contact portion 513 may be a portion of the first rotating portion 512 that comes into contact with the damper 550. The first groove 514 may extend in one direction from the first contact portion 513 not to come into contact with the damper 550. The first rotating portion 512 may come into contact with the damper 550 only in the predetermined section L through the first contact portion 513 and the first groove 514. For example, referring to FIG. 8A, the first contact portion 513 of the first rotating portion 512 may come into contact with the damper 550 in the predetermined section L depending on the degree of rotation of the first rotator 510 about the first rotation center M and may not come into contact with the damper 550 in the remaining section. In this case, the operation feeling may be improved compared to the case where the first rotating portion 512 maintains the state of being in contact with the damper 550 while the electronic device 200 is being folded or unfolded.

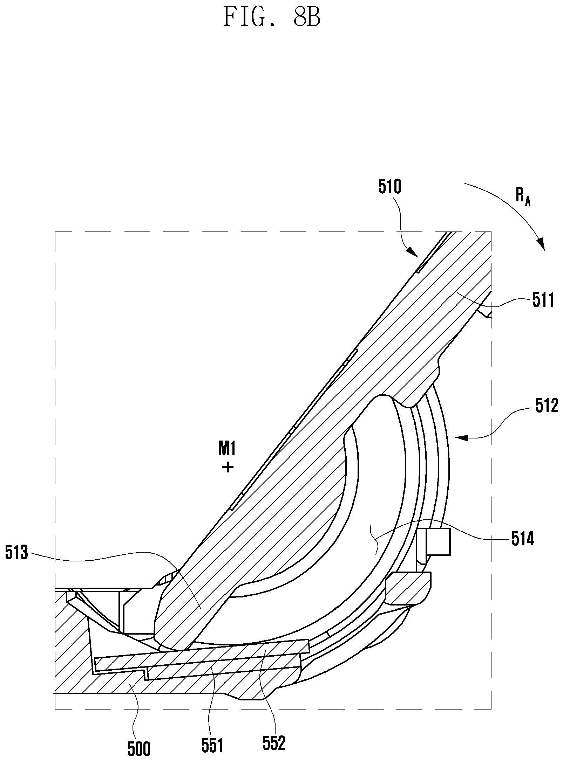

According to an embodiment, as illustrated in FIG. 8B, the first rotator 510 may rotate in a clockwise direction RA about the first rotation center M1 while the electronic device 200 is switched from the folded state to the unfolded state. The first rotating portion 512 may come into contact with the damper 550 depending on the degree of rotation of the first rotator 510. For example, as illustrated in FIG. 8B, when the first rotator 510 rotates clockwise RA by or in excess of a predetermined level about the first rotation center M1, the first contact portion 513 may not come into contact with the damper 550, and at least a portion of the damper 550 may be located in the first groove 514. Accordingly, the first rotating portion 512 and the damper 550 may not come into contact with each other in the state in which the first rotator 510 rotates clockwise RA by or in excess of a predetermined level about the first rotation center M1.

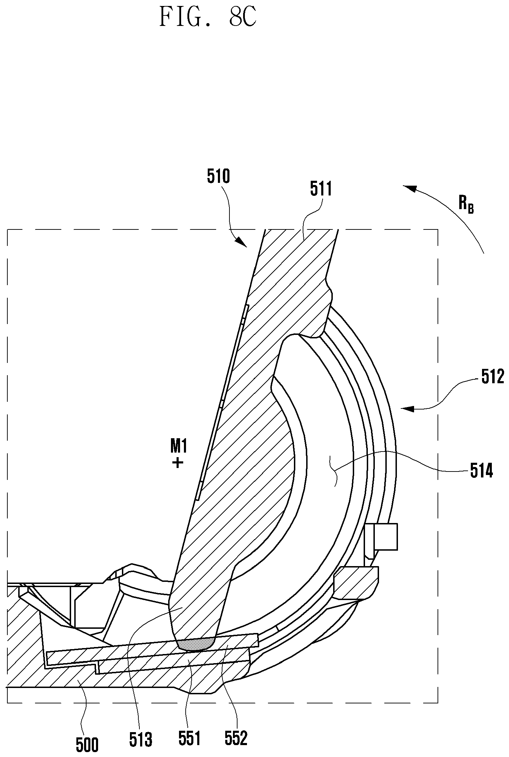

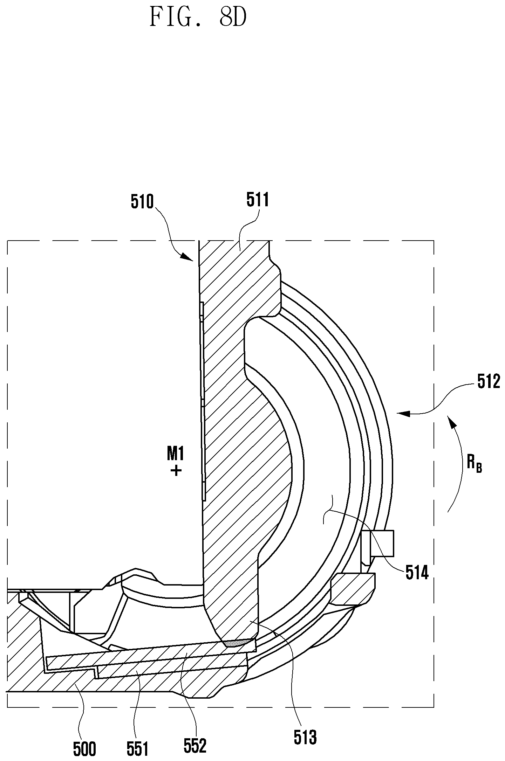

According to an embodiment, as described above, the cam structures 515 and 525 of the rotating portions 512 and 522 and the cam portions 531 and 541 of the cam slides 530 and 540, which are engaged with each other in response to the folding or unfolding operation of the electronic device 200, may generate noise depending on the operating state of the electronic device 200. In an embodiment, noise generated between the cam structures 515 and 525 and the cam portions 531 and 541 may be generated in a section in which the electronic device 200 is switched from the unfolded state to the folded state. Therefore, contact between the first rotating portion 512 and the damper 550 may be required in a specific section. In an embodiment, referring to FIGS. 8C and 8D, the first rotator 510 may rotate in a counterclockwise direction RB about the first rotation center M1 while the electronic device 200 is switched from the folded state to the unfolded state. In this case, the first contact portion 513 of the first rotating portion 512 may come into contact with the damper 550 depending on the degree of rotation in the counterclockwise direction RB about the first rotation center M1. As a result, noise or vibration generated between the cam structures 515 and 525 and the cam portions 531 and 541 may be reduced or buffered through the damper 550. For example, vibration transmitted to the pressing plate 552 of the damper 550 may be transmitted to the buffer member 551 to be offset. Thus, the operation feeling of the electronic device 200 can be improved. However, the above description is not intended to limit that noise or vibration is generated between the cam structures 515 and 525 and the cam portions 531 and 541 only while the electronic device 200 is switched from the unfolded state to the folded state. For example, noise or vibration generated between the cam structures 515 and 525 of the rotating portions 512 and 522 and the cam portions 531 and 541 of the cam slides 530 and 540 may be generated in response to the unfolding operation or the folding operation of the electronic device 200. In summary, noise may be generated between the cam structures 515 and 525 of the rotating portions 512 and 522 and the cam portions 531 and 541 of the cam slides 530 and 540 depending on the degree of rotation of the first rotator 510. In this case, the damper 550 may come into contact with the first contact portion 513 of the first rotating portion 512 in a section in which noise is generated according to the rotation of the first rotator 510.

According to an embodiment of the disclosure, an electronic device 200 includes a first housing 210, a second housing 220, and a hinge apparatus 400-1 or 400-2 configured to foldably connect the first housing and the second housing to each other. The hinge apparatus may include a bracket 500 including a first coupling portion 501 and a second coupling portion 502 spaced apart from the first coupling portion, a first rotator 510 including a first rotating portion 512 fastened to the first coupling portion of the bracket to rotate relative to the bracket, a second rotator 520 including a second rotating portion 522 fastened to the second coupling portion of the bracket to rotate relative to the bracket, and a damper 550 disposed on at least one of the first coupling portion and the second coupling portion to come into contact with at least one of the first rotating portion and the second rotating portion depending on a degree of rotation of the first rotator and the second rotator relative to the bracket.

In addition, at least one of the first rotating portion and the second rotating portion may be configured to come into contact with the damper in a predetermined section (L) depending on the degree of rotation of the first rotator and the second rotator relative to the bracket.

In addition, the damper may be seated in at least one of a first seating groove 503 provided in the first coupling portion and a second seating groove 504 provided in the second coupling portion.

In addition, the damper may include a buffer member 551 seated on at least one of the first coupling portion and the second coupling portion of the bracket, and a pressing plate 552 disposed on the buffer member to press at least one of the first rotating portion and the second rotating portion.

In addition, the buffer member may be formed of at least one of rubber, urethane, and silicon. However, it is pointed out that the pressing plate 552 is optionally provided to perform this embodiment and can be omitted.

In addition, the first rotating portion of the first rotator may include a first contact portion 513 configured to come into contact with the damper in a predetermined section L depending on the degree of rotation of the first rotator relative to the bracket, and a first groove 514 extending on the first contact portion in one direction not to come into contact with the damper in a remaining section other than the predetermined section. The second rotating portion of the second rotator may include a second contact portion 523 configured to come into contact with the damper in the predetermined section L depending on the degree of rotation of the second rotator relative to the bracket, and a second groove 524 extending on the second contact portion in one direction not to come into contact with the damper in the remaining section other than the predetermined section.

In addition, the damper may be disposed on the bracket to form a predetermined angle relative to one surface of the bracket and comes into contact with at least one of the first rotating portion and the second rotating portion.

In addition, the first rotator 510 may include a first cam structure 515 provided on the first rotating portion, and the second rotator 520 may include a second cam structure 525 provided on the second rotating portion. The hinge apparatus may include a first cam slide 530 including a first cam portion 531 configured to be engaged with the first cam structure of the first rotator, and a second cam slide 540 including a second cam portion 541 configured to be engaged with the second cam structure of the second rotator.

The electronic device may further include an elastic member 560 disposed on the bracket to press the first cam slide and the second cam slide in opposite directions.

In addition, the elastic member may include a first elastic member 561 configured to press the first cam slide in a first direction and a second elastic member 562 configured to press the second cam slide in a second direction opposite to the first direction.

In addition, the first cam structure of the first rotating portion may include a (1-1)^{th} cam structure 515-1 provided on a first surface of the first rotating portion and a (1-2)^{th} cam structure 515-2 provided on a second surface opposite to the first surface, and the second cam structure of the second rotating portion may include a (2-1)^{th} cam structure 525-1 provided on a first surface of the second rotating portion and a (2-2)^{th} cam structure 525-2 provided on a second surface opposite to the first surface. The first cam portion of the first cam slide may include a (1-1)^{th} cam portion (531-1) engaged with the (1-1)^{th} cam structure of the first rotating portion and a (1-2)^{th} cam portion (531-2) engaged with the (2-1)^{th} cam structure of the second rotating portion, and the second cam portion of the second cam slide may include a (2-1)^{th} cam portion (541-1) engaged with the (1-2)^{th} cam structure of the first rotating portion and a (2-2)^{th} cam portion (541-2) engaged with the (2-2)^{th} cam structure of the second rotating portion.

The bracket may include a plurality of separation prevention pieces 505, the first elastic member may include one end inserted into a corresponding one of the separation prevention pieces and the other end configured to press the first cam slide, and the second elastic member may include one end inserted into a corresponding one of the separation prevention pieces and the other end configured to press the second cam slide.

In addition, the first rotator may include a first plate 511 including the first rotating portion and coupled to the first housing, and the second rotator may include a second plate 521 including the second rotating portion and coupled to the second housing.

The electronic device may further include a first arm including a first gear, wherein the first arm is connected to the first rotator to be rotatable relative to the bracket and connected to the first housing, a second arm including a second gear, wherein the second arm is connected to the second rotator to be rotatable relative to the bracket and connected to the second housing, and an interlocking gear engaged with the first gear and the second gear to rotate.

A hinge apparatus 400-1 or 400-2 according to an embodiment of the disclosure may include a bracket 500 including a first coupling portion 501 and a second coupling portion 502 spaced apart from the first coupling portion, a first rotator 510 including a first rotating portion 512 fastened to the first coupling portion of the bracket to rotate relative to the bracket, a second rotator 520 including a second rotating portion 522 fastened to the second coupling portion of the bracket to rotate relative to the bracket, and a damper 550 disposed on at least one of the first coupling portion and the second coupling portion to come into contact with at least one of the first rotating portion and the second rotating portion depending on a degree of rotation of the first rotator and the second rotator relative to the bracket.

In addition, at least one of the first rotating portion and the second rotating portion may be configured to come into contact with the damper in a predetermined section (L) depending on the degree of rotation of the first rotator and the second rotator relative to the bracket.

In addition, the damper may be seated in at least one of a first seating groove 503 provided in the first coupling portion and a second seating groove 504 provided in the second coupling portion.

In addition, the damper may include a buffer member 551 seated on at least one of the first coupling portion and the second coupling portion of the bracket, and a pressing plate 552 disposed on the buffer member to press at least one of the first rotating portion and the second rotating portion.

In addition, the damper may be disposed on the bracket to form a predetermined angle relative to one surface of the bracket and comes into contact with at least one of the first rotating portion and the second rotating portion.

In addition, the first rotating portion of the first rotator may include a first contact portion 513 configured to come into contact with the damper in a predetermined section L depending on the degree of rotation of the first rotator relative to the bracket, and a first groove 514 extending on the first contact portion in one direction not to come into contact with the damper in a remaining section other than the predetermined section. The second rotating portion of the second rotator may include a second contact portion 523 configured to come into contact with the damper in the predetermined section L depending on the degree of rotation of the second rotator relative to the bracket, and a second groove 524 extending on the second contact portion in one direction not to come into contact with the damper in the remaining section other than the predetermined section.

According to an embodiment disclosed herein, since the hinge apparatus 400-1 or 400-2 having a relatively simple structure is implemented, it is possible to manufacture the hinge apparatus 400-1 or 400-2 to be compact. As a result, it is possible to reduce the volume of a hinge driver of an electronic device 200, and thus it is possible to manufacture the electronic device 200 that is compact as a whole.

In addition, a damper 550 for reducing vibration or noise generated from the hinge apparatus 400-1 or 400-2 may be disposed inside the hinge apparatus 400-1 or 400-2. Through this, vibration or noise generated from the hinge apparatus 400-1 or 400-2 may be reduced to improve the operating feeling of the electronic device 200.

According to various embodiments disclosed herein, a damper structure is provided so as to reduce vibration or noise generated from a hinge apparatus may be disposed inside the hinge apparatus. In addition, various effects directly or indirectly identified through the disclosure may be provided.

## Claims

1. An electronic device (200) comprising:
a first housing (210);
a second housing (220); and
a hinge apparatus (400-1, 400-2) configured to foldably connect the first housing (210) and the second housing (220) to each other,
wherein the hinge apparatus (400-1, 400-2) comprises:
a bracket (500) comprising a first coupling portion (501) and a second coupling portion (502) spaced apart from the first coupling portion (501);
a first rotator (510) comprising a first rotating portion (512) fastened to the first coupling portion (501) of the bracket (500) to rotate relative to the bracket (500);
a second rotator (520) comprising a second rotating portion (522) fastened to the second coupling portion (502) of the bracket (500) to rotate relative to the bracket (500); and
a damper (550) disposed on at least one of the first coupling portion (501) and the second coupling portion (502) to come into contact with at least one of the first rotating portion (512) and the second rotating portion (522) depending on a degree of rotation of the first rotator (510) and the second rotator (520) relative to the bracket (500).

2. The electronic device (200) of claim 1, wherein at least one of the first rotating portion (512) and the second rotating portion (522) is configured to come into contact with the damper (550) in a predetermined section (L) depending on the degree of rotation of the first rotator (510) and the second rotator (520) relative to the bracket (500).

3. The electronic device (200) of any one of claims 1 to 2, wherein the damper (550) is seated in at least one of a first seating groove (503) provided in the first coupling portion (501) and a second seating groove (504) provided in the second coupling portion (502).

4. The electronic device (200) of any one of claims 1 to 3, wherein the damper (550) comprises a buffer member (551) seated on at least one of the first coupling portion (501) and the second coupling portion (502) of the bracket (500), and a pressing plate (552) disposed on the buffer member (551) to press at least one of the first rotating portion (512) and the second rotating portion (522).

5. The electronic device (200) of claim 4, wherein the buffer member (551) is made of at least one of rubber, urethane, and silicone.

6. The electronic device (200) of any one of claims 1 to 5, wherein the first rotating portion (512) of the first rotator (510) comprises a first contact portion (513) configured to come into contact with the damper (550) in a predetermined section (L) depending on the degree of rotation of the first rotator (510) relative to the bracket (500), and a first groove (514) extending on the first contact portion (513) in one direction not to come into contact with the damper (550) in a remaining section other than the predetermined section (L), and
the second rotating portion (522) of the second rotator (520) comprises a second contact portion (523) configured to come into contact with the damper (550) depending on the degree of rotation of the second rotator (520) relative to the bracket (500), and a second groove (524) extending on the second contact portion (523) in one direction not to come into contact with the damper (550) in the remaining section other than the predetermined section (L).

7. The electronic device (200) of any one of claims 1 to 6, wherein the damper (550) is disposed on the bracket (500) to form a predetermined angle relative to one surface of the bracket (500) and comes into contact with at least one of the first rotating portion (512) and the second rotating portion (522).

8. The electronic device (200) of any one of claims 1 to 7, wherein the first rotator (510) comprises a first cam structure (515) provided on the first rotating portion (512),
wherein the second rotator (520) comprises a second cam structure (525) provided on the second rotating portion (522), and
wherein the hinge apparatus (400-1, 400-2) further comprises:
a first cam slide (530) comprising a first cam portion (531) configured to be engaged with the first cam structure (515) of the first rotator (510); and
a second cam slide (540) comprising a second cam portion (541) configured to be engaged with the second cam structure (525) of the second rotator (520).

9. The electronic device (200) of claim 8, further comprising an elastic member (560) disposed on the bracket (500) to press the first cam slide (530) and the second cam slide (540) in opposite directions.

10. The electronic device (200) of claim 9, wherein the elastic member (560) comprises a first elastic member (561) configured to press the first cam slide (530) in a first direction and a second elastic member (562) configured to press the second cam slide (540) in a second direction opposite to the first direction.

11. The electronic device (200) of claim 8, wherein the first cam structure (515) of the first rotating portion (512) comprises a (1-1)^{th} cam structure (515-1) provided on a first surface of the first rotating portion (512) and a (1-2)^{th} cam structure (515-2) provided on a second surface opposite to the first surface,
the second cam structure (525) of the second rotating portion (522) comprises a (2-1)^{th} cam structure (525-1) provided on a first surface of the second rotating portion (522) and a (2-2)^{th} cam structure (525-2) provided on a second surface opposite to the first surface,
the first cam portion (531) of the first cam slide (530) comprises a (1-1)^{th} cam portion (531-1) engaged with the (1-1)^{th} cam structure (515-1) of the first rotating portion (512) and a (1-2)^{th} cam portion (531-2) engaged with the (2-1)^{th} cam structure (525-1) of the second rotating portion (522), and
the second cam portion (541) of the second cam slide (540) comprises a (2-1)^{th} cam portion (541-1) engaged with the (1-2)^{th} cam structure (515-2) of the first rotating portion (512) and a (2-2)^{th} cam portion (541-2) engaged with the (2-2)^{th} cam structure (525-2) of the second rotating portion (522).

12. The electronic device (200) of claim 10, wherein the bracket (500) comprises a plurality of separation prevention pieces (505),
the first elastic member (561) comprises one end inserted into a corresponding one of the separation prevention pieces (505) and another end configured to press the first cam slide (530), and
the second elastic member (562) comprises one end inserted into a corresponding one of the separation prevention pieces (505) and another end configured to press the second cam slide (540).

13. The electronic device (200) of any one of claims 1 to 12, wherein the first rotator (510) comprises a first plate (511) comprising the first rotating portion (512) and coupled to the first housing (210), and
the second rotator (520) comprises a second plate (521) comprising the second rotating portion (522) and coupled to the second housing (220).

14. The electronic device (200) of any one of claims 1 to 13, further comprising:
a first arm comprising a first gear, wherein the first arm is connected to the first rotator (510) to be rotatable relative to the bracket (500) and connected to the first housing (210);
a second arm comprising a second gear, wherein the second arm is connected to the second rotator (520) to be rotatable relative to the bracket (500) and connected to the second housing (220); and
an interlocking gear engaged with the first gear and the second gear to rotate.
